(19) Europäisches Patentamt / European Patent Office / Office européen des brevets

(11) **EP 2 592 660 A1**

(12) **EUROPEAN PATENT APPLICATION**
published in accordance with Art. 153(4) EPC

(43) Date of publication:
**15.05.2013 Bulletin 2013/20**

(51) Int Cl.:
*H01L 31/042* (2006.01)  *C08G 63/183* (2006.01)
*C08G 63/82* (2006.01)  *C08J 5/18* (2006.01)

(21) Application number: **11803553.4**

(22) Date of filing: **04.07.2011**

(86) International application number:
**PCT/JP2011/065296**

(87) International publication number:
**WO 2012/005219 (12.01.2012 Gazette 2012/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2010 JP 2010155629**

(71) Applicant: **Mitsubishi Plastics, Inc.**
**Tokyo 100-8252 (JP)**

(72) Inventor: **NOZAWA, Koutarou**
**Maibara-shi**
**Shiga 521-0234 (JP)**

(74) Representative: **Ter Meer Steinmeister & Partner**
**Patentanwälte**
**Mauerkircherstrasse 45**
**81679 München (DE)**

(54) **BIAXIALLY ORIENTED WHITE POLYETHYLENE TEREPHTHALATE FILM AND BACK PROTECTIVE FILM FOR USE IN SOLAR CELL MODULES**

(57)    The present invention provides a biaxially oriented white polyethylene terephthalate film which can be produced at low costs and is excellent in environmental resistance (such as hydrolysis resistance and ultraviolet light resistance), and can be suitably used in the applications in which a high reflection efficiency and a reduced weight are required, and a backsheet for a photovoltaic module. The present invention relates to a biaxially oriented white polyethylene terephthalate film having a phosphorus element content of not more than 70 ppm by weight, a carboxyl end group content of not more than 26 equivalents/t, an intrinsic viscosity of not less than 0.65 dL/g, a white pigment concentration of 2.0 to 10.0% by weight and a thickness of not less than 175 μm.

EP 2 592 660 A1

**Description**

TECHNICAL FIELD

The present invention relates to a biaxially oriented white polyethylene terephthalate film which can be produced at low costs and is excellent in environmental resistance (such as hydrolysis resistance and ultraviolet light resistance), and can be suitably used in the applications in which a high reflection efficiency and a reduced weight are required, and a backsheet for a photovoltaic module.

BACKGROUND ART

In recent years, solar batteries (photovoltaic cells) have been noticed as a next-generation energy source. For this reason, there is a strong demand for a backsheet for a photovoltaic module as a part of constituent components of the photovoltaic cell which has a good durability against natural environment conditions (such as hydrolysis resistance and ultraviolet light resistance). In addition, the photovoltaic cells are also required to have a high conversion rate of sunlight into electricity, in which even light reflected on the backsheet is converted into electricity. Further, the photovoltaic cells are also required to have a reduced weight, a high strength and a good processability.

It is known that the backsheet for a photovoltaic module is formed from a polyethylene-based resin film or a polyester-based resin film, and further from a fluorine-based film (refer to Patent Documents 1 and 2).

In particular, in view of low costs and no occurrence of toxic gases upon combustion, there have been extensively developed backsheets produced from a polyethylene terephthalate film. However, the polyethylene terephthalate film tends to readily suffer from hydrolysis as well as yellowing owing to irradiation with ultraviolet rays in sunlight as compared to the fluorine-based film.

The yellowing of the polyethylene terephthalate film owing to irradiation with ultraviolet rays may be reduced by adding a white pigment to the film. The white pigment is capable of reflecting sunlight and therefore also serves to enhance an efficiency of reflection of sunlight toward the side of photovoltaic cells at the same time. However, upon forming polyethylene terephthalate comprising the white pigment into a film shape, the polymer is subjected to shearing by the white pigment during an extrusion process thereof, which tends to result in reduction in molecular weight of the polyethylene terephthalate and deterioration in hydrolysis resistance thereof.

In consequence, it is known that when a polyethylene terephthalate film comprising a high concentration of a white pigment is disposed on the side of an encapsulant and a transparent polyethylene terephthalate film having a hydrolysis resistance is disposed on an outside thereof, it is possible to obtain a back surface-protective sheet for a photovoltaic module which has both a good ultraviolet light resistance and a good hydrolysis resistance (refer to Patent Document 3).

However, since the polyethylene terephthalate film comprising a high concentration of a white pigment has a less durability, it is required that a gas-barrier film is provided between the polyethylene terephthalate film comprising a high concentration of a white pigment and the transparent polyethylene terephthalate film having a hydrolysis resistance. In this case, the process for production of such a multilayer sheet includes a step of laminating the polyethylene terephthalate film comprising a high concentration of a white pigment, the gas-barrier film and the transparent polyethylene terephthalate film having a hydrolysis resistance, so that deterioration in yield tends to be caused.

PRIOR DOCUMENTS

Patent Documents

Patent Document 1: Japanese Patent Application Laid-Open (KOKAI) No. 11-261085
Patent Document 2: Japanese Patent Application Laid-Open (KOKAI) No. 11-186575
Patent Document 3: Japanese Patent Application Laid-Open (KOKAI) No. 2002-100788

SUMMARY OF THE INVENTION

Problems to be Solved by the Invention

The present invention has been accomplished in view of the above problems in the prior art. An object of the present invention is to provide a biaxially oriented white polyethylene terephthalate film suitably used as a backsheet for a photovoltaic module which is produced at low costs and improved in environmental resistance such as hydrolysis resistance and ultraviolet light resistance, and further imparted with a high reflectance effective to obtain a high conversion rate of sunlight into electricity, as well as a backsheet for a photovoltaic module.

Means for Solving Problems

As a result of the present inventors' earnest study, it has been found that the above problems can be solved by using a specific biaxially oriented white polyethylene terephthalate film. The present invention has been attained on the basis of this finding.

That is, in a first aspect of the present invention, there is provided a biaxially oriented white polyethylene terephthalate film having a phosphorus element content of not more than 70 ppm by weight, a carboxyl end group content of not more than 26 equivalents/t, an intrinsic viscosity of not less than 0.65 dL/g, a white pigment concentration of 2.0 to 10.0% by weight and a thickness of not less than 175 $\mu$m. In a second aspect of the present invention, there is provided a backsheet for a photovoltaic module comprising the above biaxially oriented white polyethylene terephthalate film.

EFFECT OF THE INVENTION

In accordance with the present invention, there is provided a biaxially oriented white polyethylene terephthalate film suitably used as a backsheet for a photovoltaic module which is excellent in hydrolysis resistance, ultraviolet light resistance, optical density and reflectance, as well as a backsheet for a photovoltaic module.

PREFERRED EMBODIMENTS FOR CARRYING OUT THE INVENTION

The present invention is described in more detail below.
The photovoltaic cell as described in the present invention means a system for converting sunlight into electricity and accumulating the electricity therein. The photovoltaic cell preferably has a basic structure constituted from a high light transmission material, a photovoltaic module, an encapsulant layer and a back surface-protective sheet, and may be incorporated or fitted in a roof of a house or may be applied to electric or electronic parts, etc., and has a flexibility.

The high light transmission material as used herein means a material which allows sunlight to enter thereinto at a high efficiency, and serves for protecting a photovoltaic module disposed inside thereof. As the high light transmission material, there are preferably used glass and high light transmission plastics or films. In addition, the photovoltaic module is adapted to convert sunlight into electricity and accumulate the electricity, and serves as a central part of a photovoltaic cell. The photovoltaic module is constituted from a semiconductor such as silicon, cadmium-tellurium, germanium-arsenic, etc. At present, the photovoltaic module is frequently formed of monocrystalline silicon, polycrystalline silicon, amorphous silicon, etc.

Also, the encapsulant layer is used for the purposes of fixing, protecting and electrically insulating the photovoltaic module in a photovoltaic cell, and as a resin for the encapsulant layer, in particular, an ethylene-vinyl acetate resin (EVA) may be suitably used in view of a good performance and a low price.

The backsheet for a photovoltaic module as defined in the present invention has an important role of protecting the photovoltaic module on a back side of the photovoltaic cell. It is required that the backsheet has a high reflectance to sunlight in order to enhance a photoelectric conversion rate of the photovoltaic cell, maintains a good mechanical strength even when exposed to outdoor environments for a long period of time, and is in the form of a back surface protecting sheet having a less change in appearance (color tone). The change in appearance of the backsheet will remind ordinary users of deterioration in performance of the product or failure thereof.

In the present invention, the backsheet for a photovoltaic module is constituted of a biaxially oriented polyethylene terephthalate film as described in detail hereinlater, and may further comprise the other appropriate layers, if required.

The white biaxially oriented polyethylene terephthalate film according to the present invention may be suitably used as a backsheet for a photovoltaic module. The polyethylene terephthalate resin used in the polyethylene terephthalate film is a crystalline thermoplastic resin obtained by subjecting terephthalic acid and its derivative as a dicarboxylic acid component and ethylene glycol as a glycol component to esterification reaction (or transesterification reaction) and then subjecting the resulting reaction product to polycondensation reaction to obtain a higher-molecular weight polymer. As the catalyst, a titanium compound may be usually used in the esterification reaction, and a magnesium compound may be usually used in the transesterification reaction. In addition, as the co-catalyst, there may be usually used a phosphorus compound. Further, in the polycondensation reaction, as the catalyst, there may be usually used a titanium compound. The thus obtained polyethylene terephthalate preferably has a melting point of not lower than 250°c in view of a good heat resistance, and not higher than 290°C in view of a good productivity. As far as the melting point of the polyethylene terephthalate lies within the above-specified range, the other dicarboxylic acid component or the other glycol component may be copolymerized with the above components, or the other polyesters may be blended with the polyethylene terephthalate. If the other polyesters are blended with the polyethylene terephthalate, the content of the other polyesters in the whole polyester resin components is preferably not more than 50% by weight.

In the polyethylene terephthalate film according to the present invention, it is required that the content of a phosphorus element therein falls within the specific range as measured and detected using the below-mentioned fluorescent X-ray analyzer. The phosphorus element in the polyethylene terephthalate film of the present invention is usually derived from a phosphorus compound as a co-catalyst which is added upon production of the polyethylene terephthalate film.

In the present invention, it is required that the phosphorus element content P in the polyethylene terephthalate film falls within the range of not more than 70 ppm by weight. The phosphorus element content P in the polyethylene terephthalate film is preferably in the range of not more than 50 ppm by weight and more preferably not more than 40 ppm by weight. The lower limit of the phosphorus element content P in the polyethylene terephthalate film is not particularly limited, and actually about 1 ppm by weight as far as the current techniques are concerned. When the phosphorus element content in the polyethylene terephthalate film is excessively large, undesirable hydrolysis of the thus formed film tends to be accelerated.

Examples of the phosphoric acid compound include known compounds such as phosphoric acid, phosphorous acid or esters thereof, phosphonic acid compounds, phosphinic acid compounds, phosphonous acid compounds, and phosphinous acid compounds. Specific examples of the phosphoric acid compound include orthophosphoric acid, dimethyl phosphate, trimethyl phosphate, diethyl phosphate, triethyl phosphate, dipropyl phosphate, tripropyl phosphate, dibutyl phosphate, tributyl phosphate, diamyl phosphate, triamyl phosphate, dihexyl phosphate, trihexyl phosphate, diphenyl phosphate, triphenyl phosphate and ethyl acid phosphate.

Also, in order to suppress occurrence of thermal decomposition or hydrolysis, the content of a metal compound in the polyethylene terephthalate film which may act as a catalyst is preferably adjusted to as small a level as possible. On the other hand, for the purpose of enhancing a productivity of the polyethylene terephthalate film, metals such as magnesium, calcium, lithium and manganese except for those metals derived from the white pigment are usually incorporated in the polyethylene terephthalate film in an amount of preferably not more than 500 ppm by weight and more preferably not more than 400 ppm by weight to reduce a volume resistivity thereof upon melting.

In order to prevent deterioration of the back surface-sealing material for photovoltaic cell owing to an incident light leaked from between photovoltaic cells, the back surface-sealing material for photovoltaic cell preferably exhibits a high shielding property. In the present invention, a white pigment is added to a polyethylene terephthalate component to obtain a white polyethylene terephthalate film. Examples of the above white pigment include titanium dioxide, zinc oxide, zinc sulfide and barium sulfate. Among these white pigments, preferred are titanium dioxide and barium sulfate, and especially preferred is titanium dioxide.

The average particle diameter of the white pigment is preferably not less than 0.25 $\mu$m, more preferably not less than 0.28 $\mu$m and especially preferably not less than 0.3 $\mu$m. When the average particle diameter of the white pigment is less than 0.25 $\mu$m, the wavelength of the light capable of being efficiently scattered therein tends to be offset toward the low wavelength side, so that the reflectance of the resulting film in a near infrared range tends to be reduced. When the average particle diameter of the white pigment is more than 10 $\mu$m, the resulting film tends to comprise coarse particles depending upon their particle size distribution, so that there tend to arise problems such as formation of pinholes in the film. For these reasons, the average particle diameter of the white pigment is preferably not more than 10 $\mu$m.

The concentration of the white pigment in the white pigment-containing polyethylene terephthalate film is not more than 10.0% by weight and preferably not more than 8.0% by weight. When the concentration of the white pigment in the polyethylene terephthalate film is more than 10.0% by weight, a shear force tends to be undesirably applied to a high-molecular chain of the polyethylene terephthalate film by the white pigment, so that decrease in intrinsic viscosity of the film and increase in carboxyl end group content in the film tend to be induced, which tends to result in deterioration in hydrolysis resistance of the polyethylene terephthalate film. This means that the resulting film is unsuitable as a biaxially oriented white polyethylene terephthalate film for a backsheet for a photovoltaic module. On the other hand, the lower limit of the concentration of the white pigment in the polyethylene terephthalate film is preferably not less than 2.0% by weight and more preferably not less than 3.0% by weight. When the concentration of the white pigment in the polyethylene terephthalate film is less than 2.0% by weight, the resulting film might fail to exhibit a good ultraviolet light resistance and therefore tends to suffer from yellowing when allowed to stand in the outdoors for a long period of time.

The polyethylene terephthalate film of the present invention preferably has a thickness D of not less than 175 $\mu$m and more preferably not less than 200 $\mu$m in view of a good relationship between reflectance and shielding property. The upper limit of the thickness of the polyethylene terephthalate film is not particularly limited, and is usually 500 $\mu$m.

The method of incorporating the white pigment in the polyethylene terephthalate film is not particularly limited, and any conventionally known methods may be suitably used in the present invention. For example, the white pigment may be added in any optional stage of the production process of a polyethylene terephthalate component. The white pigment is preferably added in the esterification stage or after completion of the transesterification reaction to allow the polycondensation reaction to proceed. In addition, there may also be used a method of blending a slurry prepared by dispersing the white pigment in ethylene glycol or water with the polyester raw material using a vented kneading extruder, or a method of blending the dried white pigment with the polyester raw material using a kneading extruder. Meanwhile, there may be further used a method in which so-called master batch chips comprising a high concentration of the white pigment are previously prepared using a kneading extruder and then mixed with the polyester raw material comprising no white pigment or a small amount of the white pigment if necessary to produce a polyester film comprising a desired amount of the white pigment.

In the present invention, the carboxyl end group content in the polyethylene terephthalate component constituting the polyethylene terephthalate film is not more than 26 equivalents/t and preferably not more than 24 equivalents/t. When the carboxyl end group content in the polyethylene terephthalate component is more than 26 equivalents/t, the resulting polyethylene terephthalate film tends to be deteriorated in hydrolysis resistance. On the other hand, in view of the hydrolysis resistance as aimed by the present invention, the lower limit of the carboxyl end group content in the polyethylene terephthalate component is not particularly limited. However, from the viewpoints of a high polycondensation reaction efficiency and suppression of thermal decomposition in the melt extrusion step, etc., the lower limit of the carboxyl end group content in the polyethylene terephthalate component is usually about 10 equivalents/t.

Meanwhile, the carboxyl end group content as used in the present invention means the value measured using a polyethylene terephthalate film by the method described in Examples hereinlater.

In the present invention, in order to impart a good hydrolysis resistance to the polyethylene terephthalate film, in addition to adjustment of the phosphorus element content and the carboxyl end group content to the above-specified ranges, it is important that the intrinsic viscosity of the polyethylene terephthalate film is controlled to not less than 0.65 dL/g and preferably not less than 0.68 dL/g.

When the intrinsic viscosity of the polyethylene terephthalate film is less than 0.65 dL/g, the polyethylene terephthalate film tends to be deteriorated in hydrolysis resistance, so that it may be difficult to use the film under high-temperature and high-humidity conditions or outdoors for a long period of time. On the other hand, in view of the hydrolysis resistance as aimed by the present invention, the upper limit of the intrinsic viscosity of the polyethylene terephthalate film is not particularly limited. However, from the viewpoints of suppression of thermal decomposition in the melt extrusion step, etc., the upper limit of the intrinsic viscosity of the polyethylene terephthalate film is usually about 0.75 dL/g.

Meanwhile, the intrinsic viscosity as used in the present invention means the value measured using a polyethylene terephthalate film by the method described in Examples hereinlater.

In the present invention, in order to adjust the carboxyl end group content and the intrinsic viscosity of polyethylene terephthalate to the above-specified ranges, respectively, there may be used, for example, a method of shortening a residence time of polyethylene terephthalate in an extruder in a step of extruding polyethylene terephthalate chips, or the like. Also, there may be used a method of forming polyethylene terephthalate chips having a low carboxyl end group content into a film shape to thereby obtain a polyethylene terephthalate film whose carboxyl end group content lies within the above-specified range. As the method of reducing the carboxyl end group content of the polyethylene terephthalate chips, there may be used conventionally known methods such as a method of subjecting the polyethylene terephthalate chips obtained by melt-polymerization to solid state polymerization, a method of enhancing a polymerization efficiency, a method of increasing a polymerization rate, and a method of suppressing a decomposition rate. These methods may be specifically accomplished, for example, by a method of shortening a melt-polymerization time, a method of increasing an amount of a polymerization catalyst used, a method of using a polymerization catalyst having a high activity, a method of lowering a polymerization temperature, etc. Also, upon production of the polyethylene terephthalate film, when a reclaimed raw material obtained through the melting step is compounded therein, the carboxyl end group content of the resulting film tends to be increased. Therefore, in the present invention, it is preferred that none of such a reclaimed raw material is compounded, or even when compounded, the amount of the reclaimed raw material compounded is preferably not more than 20 parts by weight.

Meanwhile, in the polyethylene terephthalate film of the present invention, various conventionally known additives such as an antioxidant, a thermal stabilizer, a lubricant, an antistatic agent, a fluorescent brightener, a dye and an ultraviolet absorber may be added, if required.

In the following, the process for producing the polyethylene terephthalate film according to the present invention is more specifically explained. However, the following production process is only illustrative and not intended to limit the present invention thereto, and the other modification and changes are also possible as long as they satisfy the subject matter of the present invention.

That is, polyethylene terephthalate chips which are dried by known methods or kept undried are fed to a kneading extruder and heated to a temperature not lower than a melting point of the respective polymer components for melting the chips. Then, the thus obtained molten polymers are extruded through a die onto a rotary chilled drum and rapidly cooled to a temperature not higher than a glass transition temperature thereof and solidified, thereby obtaining a substantially amorphous unoriented sheet. In this case, in order to enhance flatness of a surface of the thus obtained sheet, it is preferred to enhance adhesion of the sheet to the rotary chilled drum. For this purpose, in the present invention, an electrostatic pinning method and/or a liquid coating adhesion method are preferably used. Even in the melt extrusion step, the carboxyl end group content in the polymers tends to be increased depending upon the conditions used. Therefore, in the present invention, there are preferably adopted a method of shortening a residence time of the polyethylene terephthalate in the extruder during the extrusion step, a method of previously drying the raw material to a sufficient extent such that the water content therein is controlled to not more than 50 ppm and preferably not more than 30 ppm in the case of using a single-screw extruder, a method of providing a vent port on a twin-screw extruder to maintain an inside of the extruder at a reduced pressure of not more than 40 hPa, preferably not more than 30 hPa and more preferably not more than 20 hPa, etc.

In the present invention, the thus obtained sheet is biaxially oriented by drawing to form a film. More specifically, the drawing may be conducted under the following conditions. That is, the unoriented sheet is preferably drawn in a longitudinal direction thereof at a temperature of 70 to 145°C and a draw ratio of 2 to 6 times to form a longitudinally monoaxially oriented film, and then the monoaxially oriented film is oriented in a lateral direction thereof at a temperature of 90 to 160°C and a draw ratio of 2 to 6 times, and further the resulting biaxially oriented film is preferably subjected to heat-setting at a temperature of 160 to 220°C for 1 to 600 sec.

Further, upon the heat-setting, in the heat-treating maximum temperature zone and/or a cooling zone located at an outlet of the heat-treating zone, the resulting film is preferably subjected to relaxation by 0.1 to 20% in longitudinal and/or lateral directions thereof. In addition, the resulting film may be subjected to longitudinal drawing and lateral drawing again, if required.

In the present invention, as described above, using two or three or more melting extruders for polyethylene terephthalate, it is possible to produce a multilayer polyethylene terephthalate film having two layers or three or more layers by a so-called co-extrusion method. As the layer structure of the resulting multilayer polyethylene terephthalate film, there may be mentioned a layer structure of A/B or A/B/A using a raw material A and a raw material B, a layer structure of A/B/C further using a raw material C, and the other layer structures.

The hydrolysis resistance of the polyethylene terephthalate film is a property associated with a whole portion of the polyethylene terephthalate film. In the present invention, in the case of the polyethylene terephthalate film having a multilayer structure which is produced by the co-extrusion method, it is required that the intrinsic viscosity and the carboxyl end group content of the polyethylene terephthalate component constituting the polyethylene terephthalate film as a whole respectively fall within the above-specified ranges. Similarly, in the case of the polyethylene terephthalate film having a multilayer structure which is produced by the co-extrusion method, it is required that the phosphorus element content and the white pigment concentration of the polyethylene terephthalate component constituting the polyethylene terephthalate film as a whole respectively fall within the above-specified ranges.

In the present invention, during or after the above drawing step, in order to impart an adhesion property, an antistatic property, a slip property, a releasing property, etc., to the polyethylene terephthalate film, a coating layer may be formed on one or both surfaces of the polyethylene terephthalate film, or the polyethylene terephthalate film may be subjected to discharge treatment such as corona treatment.

EXAMPLES

The present invention is described in more detail below by the following Examples. However, these Examples are only illustrative and not intended to limit the present invention thereto, and other variations and modifications are possible unless they depart from the scope of the present invention. Meanwhile, the methods for measuring and evaluating various properties of the film are as follows.

(1) Content of white pigment ($TiO_2$)/quantitative determination of respective elements derived from catalyst:

Using a fluorescent X-ray analyzer "XRF-1500" manufactured by Shimadzu Corp., the contents of the respective elements in the polyethylene terephthalate film were determined by a single sheet measurement method under the conditions shown in Table 1 below. In the case of a multilayer polyethylene terephthalate film, the polyethylene terephthalate film was melted and molded into a disk shape to measure contents of the respective elements based on a whole amount of the polyethylene terephthalate film. Meanwhile, in the case where the white pigment was contained in the polyethylene terephthalate film, a peak attributed to the white pigment was detected. Therefore, after removing the white pigment from a whole portion of the polyethylene terephthalate film, the film was subjected to quantitative determination of the respective elements derived from the catalyst in the polyethylene terephthalate component.

Table 1

| | Ti | P | Mg |
|---|---|---|---|
| X-ray tube target | Rh 4.0 kW | Rh 4.0 kW | Rh 4.0 kW |
| Voltage (kV) | 40 | 40 | 40 |
| Current (mA) | 95 | 95 | 95 |
| Analyzing crystal | LiF | Ge | TAP |
| Detector | SC | FPC | FPC |
| $2\theta$ (deg) | 86.14 | 141.03 | 36.85 |
| Measuring time (sec); two-point background; 20 sec for each | 40.0 | 40.0 | 40.0 |

In Table 1, Ti represents a titanium element; P represents a phosphorus element; and $TiO_2$ content was proved by a peak attributed to Ti.

(2) Intrinsic viscosity IV [dL/g]:

The polyethylene terphthalate sample (resin or film) in an amount of 0.5 g was dissolved in a mixed solvent comprising phenol and tetrachloroethane at a weight ratio of 50/50. The resulting solution having a concentration of 1.0 (g/dL) was subjected to measurement of a falling time thereof using a capillary tube viscometer, and the solvent only was also subjected to the same measurement of a falling time thereof. The intrinsic viscosity IVappa of the sample was calculated from a ratio between the falling times according to a Huggins' formula in which a Huggins' constant was assumed to be 0.33. From the thus measured IVappa, the intrinsic viscosity IV was determined using the white pigment content ($\phi$% by weight) according to the following formula.
$$IV = \frac{IV_{appa}}{1 - \dfrac{\phi}{100}}$$

(3) Carboxyl end group content AV (equivalent/t):

The polyethylene terephthalate sample (resin or film) was subjected to a so-called titration method to measure an apparent carboxyl end group content AVappa thereof. The sample was milled and then dried at 140°C for 15 min using a hot air dryer, and further cooled to room temperature in a desiccator. Then, the sample was accurately weighed in an amount of 0.1 g and placed in a test tube. The test tube was further charged with 3 mL of benzyl alcohol, and the contents of the test tube were dissolved at 195°C for 3 min while blowing a dry nitrogen gas thereinto. Next, 5 mL of chloroform were gradually added to the resulting solution, and the contents of the test tube were cooled to room temperature. One or two droplets of a phenol red indicator were added to the above solution, and the solution was subjected to titration using a 0.1 N sodium hydroxide solution (solvent: water/methanol/benzyl alcohol) under stirring while blowing a dry nitrogen gas thereinto. The titration was terminated at the time at which the color of the solution was changed from yellow to red. In addition, the above materials except for the sample as a blank were subjected to the same procedure as described above to calculate an apparent carboxyl end group content AVappa of the polyethylene terephthalate sample according to the following formula.
```
AVappa [equivalent/t] = (A - B) x 0.1 x f/W
```

wherein A is an amount ($\mu$L) of the 0.1 N sodium hydroxide benzyl alcohol solution used in titration of the polyethylene terephthalate sample; B is an amount ($\mu$L) of the 0.1 N sodium hydroxide benzyl alcohol solution used in titration of the blank; W is an amount (g) of the sample; and f is a titer of the 0.1 N sodium hydroxide benzyl alcohol solution.

From the thus measured apparent carboxyl end group content AVappa, the carboxyl end group content of the polyethylene terephthalate sample was determined using the white pigment content ($\phi$% by weight) according to the following formula.
$$AV = \frac{AV_{appa}}{1 - \frac{\phi}{100}}$$

Meanwhile, the titer (f) of the 0.1 N sodium hydroxide benzyl alcohol solution was measured as follows. That is, 5 mL of methanol was sampled in a test tube, and one or two droplets of a phenol red ethanol solution as an indicator were added to the test tube, and the resulting solution was subjected to titration using 0.4 mL of a 0.1 N sodium hydroxide benzyl alcohol solution until reaching a point at which a color of the solution was changed. Next, 0.2 mL of a 0.1 N hydrochloric acid aqueous solution as a standard solution having a known titer was sampled and added to the test tube and subjected again to titration using the 0.1 N sodium hydroxide benzyl alcohol solution until reaching a point at which a color of the solution was changed. The above procedures were conducted while blowing a dry nitrogen gas into the solution to be titrated. The titer (f) was calculated according to the following formula.
    Titer (f) = (titer of the 0.1 N hydrochloric acid
    aqueous solution) x (amount ($\mu$L) of 0.1 N hydrochloric acid
    aqueous solution sampled)/(amount ($\mu$L) of the 0.1 N sodium
    hydroxide benzyl alcohol solution used in the titration)

(4) Hydrolysis resistance:

The polyethylene terephthalate film was treated in an atmosphere of 85°C and 85% RH for 2000 hr, and an elongation at break of the film as mechanical properties thereof was measured. The retention rate (%) of the elongation at break between before and after the above treatment was calculated from the following formula, and the hydrolysis resistance of the film was evaluated according to the following ratings.
    Retention rate of elongation at break = (elongation at
    break after treatment) ÷ (elongation at break before
    treatment) x 100

A: The retention rate was not less than 20%;
B: The retention rate was not less than 6% and less than 20%; and
C: The retention rate was less than 6%.

(5) Evaluation of ultraviolet light resistance:

<(A) Accelerated ultraviolet light resistance test>

The polyethylene terephthalate film was subjected to accelerated ultraviolet light resistance test under the following conditions.
Apparatus: Metal Weather tester (type/maker: "KW-R5TP"/Daypla Wintes Co., Ltd.)
Irradiance: 100 mW/cm$^2$
Irradiation conditions: BP: 63°C; humidity: 50%
Filter: KF-2
Treatment time: 12 hr

<u><(B) Method for evaluation of ultraviolet light resistance></u>

The hue values (L\*, a\* and b\*) of the polyethylene terephthalate film before and after subjected to weathering test were measured by a reflection method using a spectrophotometer "CM-3730d" manufactured by Konica-Minolta Corp., to determine a color difference ($\Delta$Eab) and evaluate a ultraviolet light resistance of the polyethylene terephthalate film according to the color difference value.
Hue values before weathering test: $L^*_1$, $a^*_1$ and $b^*_1$
Hue values after weathering test: $L^*_2$, $a^*_2$ and $b^*_2$
$$\Delta Eab = \{(L^*_2 - L^*_1)^2 + (a^*_2 - a^*_1)^2 + (b^*_2 - b^*_1)^2\}^{0.5}$$

    A: Less than 10;
    B: Not less than 10 and less than 12; and
    C: Not less than 12.

<u>(6) Evaluation of optical density:</u>

Using a Macbeth densitometer "TD-904 Type", the polyethylene terephthalate film was subjected to single sheet measurement. The value indicated by the meter was read out after being stabilized. The optical density of the film was evaluated from the thus measured value according to the following ratings.

    A: Optical density was not less than 1.0;
    B: Optical density was not less than 0.7 and less than 1.0;
    C: Optical density was not less than 0.5 and less than 0.7; and
    D: Optical density was less than 0.5.

<u>(7) Evaluation of light reflectance:</u>

Using "UV-3100" manufactured by Shimadzu Corp., the reflectance of the film at a wavelength of 550 nm was measured by diffusion reflection method.
    A: Not less than 85%;
    B: Not less than 80% and less than 85%; and
    C: Less than 80%.

[Production Example 1]

<u><Method of producing polyethylene terephthalate resin (1)></u>

A transesterification reaction vessel equipped with a stirrer and a rectifying column was charged with 1700 parts by weight of dimethyl terephthalate and 1200 parts by weight of ethylene glycol, and 1.39 parts by weight of magnesium acetate tetrahydrate as a transesterification reaction catalyst were added thereto. The transesterification reaction was conducted at a reaction temperature of 150 to 240°C under normal pressures for 4 hr while distilling off methanol as produced by the reaction, thereby obtaining a low-molecular weight polyester (oligomer; transesterification reaction rate: 99.5%) as a transesterification reaction product. The thus obtained oligomer was transferred to a polycondensation reaction vessel equipped with a stirrer and a distilling tube. Thereafter, an ethylene glycol solution comprising 0.57 part by weight of ethyl acid phosphate having an average molecular weight of 140.01 and further, after the elapse of 20 min, an ethylene glycol solution comprising 0.24 part by weight of tetrabutyl titanate were added to the oligomer thus transferred. Furthermore, 51 parts by weight of silica particles were added to the oligomer. The silica particles were added in the form of a slurry prepared by dispersing the silica particles in ethylene glycol (silica particles: "SL320" produced by Fuji Silysia Chemical Ltd.). After adding the silica particles, the reaction pressure in the reaction vessel was gradually reduced from normal pressures until reaching 0.2 kPa, and the reaction temperature in the reaction vessel was raised from 240°C to 280°C, followed by subjecting the contents of the reaction vessel to polycondensation reaction at 280°C. After the elapse of 214 min from initiation of reduction of the reaction pressure, the reaction pressure in the reaction vessel was returned to normal pressures, and the polycondensation reaction was terminated. The resulting polycondensation reaction product was withdrawn from a bottom of the reaction vessel and extruded into strands, and the thus extruded strands were cut while being cooled with water to thereby obtain pellets of a polyethylene terephthalate resin (1). The results of analysis of the thus obtained polyethylene terephthalate resin (1) are shown in Table 2.

[Production Example 2]

<Method of producing polyethylene terephthalate resin (2)>

A slurry preparation vessel was connected in series to two-stage esterification reaction vessels of which the second-stage esterification reaction vessel was in turn connected in series to three-stage melt-polycondensation reaction vessels to thereby provide a continuous polymerization apparatus. The slurry preparation vessel was continuously charged with terephthalic acid and ethylene glycol at weight ratio of 865:485, and further a 0.3 wt% ethylene glycol solution of ethyl acid phosphate was continuously added thereto in such an amount that the content P of phosphorus atom per 1 ton of the resulting polyester resin was 6 ppm by weight, and then the contents of the slurry preparation vessel were stirred and mixed together to thereby prepare a slurry. The thus prepared slurry was continuously delivered to the first-stage esterification reaction vessel which was held at a temperature of 260°C under a relative pressure of 50 kPaG in a nitrogen atmosphere and in which an average residence time of the slurry was adjusted to 4 hr, and then to the second-stage esterification reaction vessel which was held at a temperature of 260°C under a relative pressure of 5 kPaG in a nitrogen atmosphere and in which an average residence time of the slurry was adjusted to 1.5 hr, to thereby subject the slurry to esterification reaction.
Also, a 0.6 wt% ethylene glycol solution of magnesium acetate tetrahydrate was continuously added to the second-stage esterification reaction vessel through a conduit fitted to an upper portion of the second-stage esterification reaction vessel in such an amount that the content M of magnesium atom per 1 ton of the resulting polyester resin was 6 ppm by weight.
Successively, the thus obtained oligomer was continuously delivered to the melt polycondensation reaction vessels. Upon the delivery, while continuously adding an ethylene glycol solution of tetra-n-butyl titanate whose titanium atom concentration and water concentration were adjusted to 0.15% by weight and 0.5% by weight, respectively, to the oligomer delivered through a transport conduit in such an amount that the content of titanium atom per 1 ton of the resulting polyester resin was 4 ppm by weight, the oligomer was continuously delivered to the first-stage melt polycondensation reaction vessel set to a temperature of 270°C and a pressure of 2.6 kPa and then to the second-stage melt polycondensation reaction vessel set to a temperature of 278°C and a pressure of 0.5 kPa, and further to the third-stage melt polycondensation reaction vessel set to a temperature of 280°C and a pressure of 0.3 kPa. The melt polycondensation reaction was conducted while controlling the residence times in the respective polycondensation reaction vessels such that the intrinsic viscosity of the resulting polyester resin was 0.650 dL/g. The obtained polycondensation reaction product was continuously withdrawn into a strand shape from a discharge port provided on a bottom of the polycondensation reaction vessel, cooled with water, and cut using a cutter, thereby obtaining pellets of a polyethylene terephthalate resin (2). The results of analysis of the thus obtained polyethylene terephthalate resin (2) are shown in Table 2.

[Production Example 3]

<Method of producing polyethylene terephthalate resin (3)>

The polyethylene terephthalate resin (2) was continuously fed into a stirring crystallization device held at a temperature of about 160°C in a nitrogen atmosphere such that the residence time of the polyethylene terephthalate resin in the device was about 60 min, and crystallized therein. Thereafter, the thus crystallized resin was continuously fed into a column-type solid state polycondensation apparatus and then subjected to solid state polycondensation reaction at 210°C under atmospheric pressure in a nitrogen atmosphere while controlling a residence time of the resin therein to 16 hr, thereby obtaining a polyethylene terephthalate resin (3). The results of analysis of the thus obtained polyethylene terephthalate resin (3) are shown in Table 2.

[Production Example 4]

<Method of producing polyethylene terephthalate resin (4)>

The same procedure as in the method of producing the polyethylene terephthalate resin (2) was conducted except that the amount of ethyl acid phosphate added was changed such that the content P of phosphorus atom was 10 ppm by weight, the amount of magnesium acetate added was changed such that the content of magnesium atom was 15 ppm by weight, and the amount of tetra-n-butyl titanate added was changed such that the content of titanium atom was 8 ppm by weight, thereby obtaining a polyethylene terephthalate resin (4). The results of analysis of the thus obtained polyethylene terephthalate resin (4) are shown in Table 2.

[Production Example 5]

<Method of producing polyethylene terephthalate resin (5)>

The polyethylene terephthalate resin (4) was continuously fed into a stirring crystallization device held at a temperature of about 160°C in a nitrogen atmosphere such that the residence time of the polyethylene terephthalate resin in the device was about 60 min, and crystallized therein. Thereafter, the thus crystallized resin was continuously fed into a column-type solid state polycondensation apparatus and then subjected to solid state polycondensation reaction at 210°C under atmospheric pressure in a nitrogen atmosphere while controlling a residence time of the resin therein to 16 hr, thereby obtaining a polyethylene terephthalate resin (5). The results of analysis of the thus obtained polyethylene terephthalate resin (5) are shown in Table 2.

[Production Example 6]

<Method of producing polyethylene terephthalate resin (6)>

A reaction vessel was charged with 100 parts by weight of dimethyl terephthalate and 60 parts by weight of ethylene glycol as starting materials as well as 0.02 part by weight of magnesium acetate tetrahydrate as a catalyst, and the reaction temperature in the reaction vessel was gradually raised from 150°C as a reaction initiation temperature while distilling off methanol as produced until reaching 230°C after 3 hr. After the elapse of 4 hr, the transesterification reaction was substantially terminated. The resulting reaction mixture was mixed with 0.03 part by weight of ethyl acid phosphate and then transferred to a polycondensation reaction vessel. Then, the reaction mixture was mixed with 0.04 part by weight of antimony trioxide, and the obtained mixture was subjected to polycondensation reaction for 4 hr. That is, in the above polycondensation reaction, the reaction temperature was gradually raised from 230°C and finally allowed to reach 280°C. On the other hand, the reaction pressure was gradually dropped from normal pressures and finally allowed to reach 0.3 mmHg. After initiation of the reaction, the change in agitation power in the reaction vessel was monitored, and the reaction was terminated at the time at which the agitation power reached the value corresponding to an intrinsic viscosity of 0.63. The resulting polymer was withdrawn from the reaction vessel under application of a nitrogen pressure, and formed into strands, and the obtained strands were cooled with water, and cut using a cutter, thereby obtaining pellets of a polyethylene terephthalate resin (prepolymer). The resulting polyester resin (prepolymer) pellets as a starting material were subjected to solid state polymerization under vacuum at 220°C, thereby obtaining a polyester resin (6). The results of analysis of the thus obtained polyethylene terephthalate resin (6) are shown in Table 2.

[Production Example 7]

<Method of producing polyethylene terephthalate resin (7)>

A reaction vessel was charged with 100 parts by weight of dimethyl terephthalate and 60 parts by weight of ethylene glycol as starting materials as well as 441 ppm by weight of magnesium acetate tetrahydrate as a catalyst, and the reaction temperature in the reaction vessel was gradually raised from 150°C as a reaction initiation temperature while distilling off methanol as produced until reaching 230°C after 3 hr. After the elapse of 4 hr, the transesterification reaction was substantially terminated. The resulting reaction mixture was transferred to a polycondensation reaction vessel, and orthophosphoric acid in an amount of 1000 ppm by weight in terms of phosphorus and then germanium dioxide were added thereto, followed by subjecting the resulting mixture to polycondensation reaction for 4 hr. That is, in the above polycondensation reaction, the reaction temperature was gradually raised from 230°C and finally allowed to reach 280°C. On the other hand, the reaction pressure was gradually dropped from normal pressures and finally allowed to reach 0.3 mmHg. After initiation of the reaction, the change in agitation power in the reaction vessel was monitored, and the reaction was terminated at the time at which the agitation power reached the value corresponding to an intrinsic viscosity of 0.62. The resulting polymer was withdrawn from the reaction vessel under application of a nitrogen pressure, thereby obtaining a polyethylene terephthalate resin (7). The results of analysis of the thus obtained polyethylene terephthalate resin (7) are shown in Table 2.

[Production Example 8]

<Method of producing titanium dioxide master batch (T-MB)>

Fifty parts by weight of the polyethylene terephthalate resin (2) and 50 parts by weight of titanium dioxide particles having an average particle diameter of 0.45 $\mu$m were melted and mixed with each other in an extruder by an ordinary method at 290°C, thereby obtaining pellets of a master batch (T-MB). The thus obtained master batch was referred to as a polyethylene terephthalate resin (8), and the results of analysis of the thus obtained polyethylene terephthalate resin (8) are shown in Table 2.

[Examples 1 to 6]

The polyethylene terephthalate resins (1) to (7) and the polyethylene terephthalate resin (8) (T-MB pellets) were mixed with each other at such a mixing ratio as shown in Table 3. The resulting polyethylene terephthalate resin mixture was melted and extruded at 290°C using a vented twin-screw extruder and cast onto a cooling roll whose surface temperature was set to 40°C by an electrostatic pinning method, thereby forming an unoriented sheet. Next, the thus obtained sheet was oriented at 88°C at a draw ratio of 3.7 times in a longitudinal direction thereof. Then, the resulting monoaxially oriented sheet was introduced into a tenter, and drawn at 120°C at a draw ratio of 3.9 times in a lateral direction thereof. The thus biaxially oriented sheet was further subjected to heat-setting at 225°C, thereby obtaining a polyester film having a thickness D of 250 $\mu$m.
The results of analysis of the thus obtained polyethylene terephthalate films are shown in Table 3. In addition, the results of evaluation of hydrolysis resistance, ultraviolet light resistance, optical density and light reflectance of the polyethylene terephthalate films are shown in Table 4.

[Example 7]

The polyethylene terephthalate resin (1), the polyethylene terephthalate resin (3), the polyethylene terephthalate resin (7) and the polyethylene terephthalate resin (8) (T-MB pellets) were mixed with each other at such a mixing ratio as shown in Table 3. The resulting polyethylene terephthalate resin mixture was melted and extruded at 290°C using a vented twin-screw extruder and cast onto a cooling roll whose surface temperature was set to 40°C by an electrostatic pinning method, thereby forming an unoriented sheet. Next, the thus obtained sheet was drawn at 88°C at a draw ratio of 3.7 times in a longitudinal direction thereof. Then, the resulting monoaxially oriented sheet was introduced into a tenter, and drawn at 115°C at a draw ratio of 3.9 times in a lateral direction thereof. The thus biaxially oriented sheet was further subjected to heat-setting at 230°C, thereby obtaining a polyester film having a thickness D of 188 $\mu$m. The results of analysis of the thus obtained polyethylene terephthalate film are shown in Table 3. In addition, the results of evaluation of hydrolysis resistance, ultraviolet light resistance, optical density and light reflectance of the polyethylene terephthalate film are shown in Table 4.

[Comparative Example 1]

The polyethylene terephthalate resin (1), the polyethylene terephthalate resin (3), the polyethylene terephthalate resin (4) and the polyethylene terephthalate resin (8) (T-MB pellets) were mixed with each other at such a mixing ratio as shown in Table 5. The resulting polyethylene terephthalate resin mixture was melted and extruded at 290°C using a vented twin-screw extruder and cast onto a cooling roll whose surface temperature was set to 40°C by an electrostatic pinning method, thereby forming an unoriented sheet. Next, the thus obtained sheet was drawn at 88°C at a draw ratio of 3.7 times in a longitudinal direction thereof. Then, the resulting monoaxially oriented sheet was introduced into a tenter, and drawn at 110°C at a draw ratio of 3.9 times in a lateral direction thereof. The thus biaxially oriented sheet was further subjected to heat-setting at 235°C, thereby obtaining a polyethylene terephthalate film having a thickness D of 150 $\mu$m. The results of analysis of the thus obtained polyethylene terephthalate film are shown in Table 5. In addition, the results of evaluation of hydrolysis resistance, ultraviolet light resistance, optical density and light reflectance of the polyethylene terephthalate film are shown in Table 6.

[Comparative Examples 2 to 6]

The polyethylene terephthalate resins (1) to (7) and the polyethylene terephthalate resin (8) (T-MB pellets) were mixed with each other at such a mixing ratio as shown in Table 5. The resulting polyethylene terephthalate resin mixture was melted and extruded at 290°C using a vented twin-screw extruder and cast onto a cooling roll whose surface temperature was set to 40°C by an electrostatic pinning method, thereby forming an unoriented sheet. Next, the thus obtained sheet was oriented at 88°C at a draw ratio of 3.7 times in a longitudinal direction thereof. Then, the resulting monoaxially oriented sheet was introduced into a tenter, and oriented at 120°C at a draw ratio of 3.9 times in a lateral direction thereof. The thus biaxially oriented sheet was further subjected to heat-setting at 230°C, thereby obtaining a polyethylene terephthalate film having a thickness D of 250 $\mu$m. The results of analysis of the thus obtained polyethylene terephthalate films are shown in Table 5. In addition, the results of evaluation of hydrolysis resistance, ultraviolet light resistance, optical density and light reflectance of the polyethylene terephthalate films are shown in Table 6.

## Table 2

| Polyethylene terephthalate resin | Intrinsic viscosity IV [dL/g] | Carboxyl end group content AV [equivalent/t] |
|---|---|---|
| (1) | 0.643 | 25 |
| (2) | 0.650 | 18 |
| (3) | 0.820 | 12 |
| (4) | 0.638 | 28 |
| (5) | 0.700 | 24 |
| (6) | 0.850 | 34 |
| (7) | 0.620 | 45 |
| (8) | 0.510 | 84 |

## Table 2 (continued))

| Polyethylene terephthalate resin | Contents of elements derived from catalyst [ppm by weight] | | | White pigment (TiO$_2$) content [wt%] |
|---|---|---|---|---|
| | Ti | Mg | P | |
| (1) | 20 | 93 | 74 | 0 |
| (2) | 4 | 6 | 6 | 0 |
| (3) | 4 | 6 | 6 | 0 |
| (4) | 8 | 15 | 10 | 0 |
| (5) | 8 | 15 | 10 | 0 |
| (6) | 0 | 32 | 66 | 0 |
| (7) | 0 | 69 | 1000 | 0 |
| (8) | 50 | 0 | 6 | 50 |

Table 3

|  | Examples | | | |
|---|---|---|---|---|
|  | 1 | 2 | 3 | 4 |
| Polyethylene terephthalate resin (1) | 3 | 4 | 4 | 4 |
| Polyethylene terephthalate resin (2) | 0 | 0 | 5 | 0 |
| Polyethylene terephthalate resin (3) | 85 | 82 | 72 | 65 |
| Polyethylene terephthalate resin (4) | 0 | 0 | 0 | 20 |
| Polyethylene terephthalate resin (5) | 0 | 0 | 0 | 0 |
| Polyethylene terephthalate resin (6) | 0 | 0 | 0 | 0 |
| Polyethylene terephthalate resin (7) | 2 | 0 | 5 | 5 |
| Polyethylene terephthalate resin (8) | 10 | 14 | 14 | 6 |
| Thickness D [$\mu$m] | 250 | 250 | 250 | 250 |
| White pigment concentration W [wt%] | 5.00 | 7.00 | 7.00 | 3.00 |
| Phosphorus content P [ppm by weight] | 29 | 9 | 62 | 61 |
| Intrinsic viscosity IV [dL/g] | 0.707 | 0.702 | 0.682 | 0.668 |
| Carboxyl end group content AV [equivalent/t] | 21.9 | 23.0 | 25.1 | 24.8 |

## Table 3 (continued)

| | Examples | | |
|---|---|---|---|
| | 5 | 6 | 7 |
| Polyethylene terephthalate resin (1) | 3 | 3 | 3 |
| Polyethylene terephthalate resin (2) | 0 | 0 | 0 |
| Polyethylene terephthalate resin (3) | 80 | 90 | 90 |
| Polyethylene terephthalate resin (4) | 0 | 0 | 0 |
| Polyethylene terephthalate resin (5) | 5 | 0 | 0 |
| Polyethylene terephthalate resin (6) | 0 | 0 | 0 |
| Polyethylene terephthalate resin (7) | 2 | 2 | 2 |
| Polyethylene terephthalate resin (8) | 10 | 5 | 5 |
| Thickness D [$\mu$m] | 250 | 250 | 188 |
| White pigment concentration W [wt%] | 5.00 | 2.50 | 2.50 |
| Phosphorus content P [ppm by weight] | 29 | 28 | 28 |
| Intrinsic viscosity IV [dL/g] | 0.701 | 0.716 | 0.716 |
| Carboxyl end group content AV [equivalent/t] | 22.5 | 19.9 | 19.9 |

Table 4

Table 4

| | Examples | | | | | | |
|---|---|---|---|---|---|---|---|
| | 1 | 2 | 3 | 4 | 5 | 6 | 7 |
| Hydrolysis resistance | A | A | B | B | A | A | A |
| Ultraviolet light resistance | B | A | A | B | B | B | B |
| Optical density | A | A | A | B | A | B | C |
| Light reflectance | A | A | A | A | A | A | B |

Table 5

| | Comparative Examples | | |
|---|---|---|---|
| | 1 | 2 | 3 |
| Polyethylene terephthalate resin (1) | 4 | 4 | 2 |
| Polyethylene terephthalate resin (2) | 0 | 0 | 30 |
| Polyethylene terephthalate resin (3) | 79.5 | 44 | 53 |
| Polyethylene terephthalate resin (4) | 10 | 15 | 0 |
| Polyethylene terephthalate resin (5) | 0 | 0 | 0 |
| Polyethylene terephthalate resin (6) | 0 | 20 | 0 |
| Polyethylene terephthalate resin (7) | 2 | 2 | 5 |
| Polyethylene terephthalate resin (8) | 4.5 | 15 | 10 |
| Thickness D [$\mu$m] | 150 | 250 | 250 |
| White pigment concentration W [wt%] | 2.25 | 7.5 | 5 |
| Phosphorus content P [ppm by weight] | 30 | 44 | 60 |
| Intrinsic viscosity IV [dL/g] | 0.696 | 0.673 | 0.644 |
| Carboxyl end group content AV [equivalent/t] | 21.5 | 31.5 | 24.7 |

## Table 5 (continued)

| | Comparative Examples | | |
|---|---|---|---|
| | 4 | 5 | 6 |
| Polyethylene terephthalate resin (1) | 4 | 3 | 4 |
| Polyethylene terephthalate resin (2) | 0 | 0 | 0 |
| Polyethylene terephthalate resin (3) | 81 | 79 | 70 |
| Polyethylene terephthalate resin (4) | 10 | 0 | 0 |
| Polyethylene terephthalate resin (5) | 0 | 0 | 0 |
| Polyethylene terephthalate resin (6) | 0 | 0 | 0 |
| Polyethylene terephthalate resin (7) | 2 | 8 | 2 |
| Polyethylene terephthalate resin (8) | 3 | 10 | 24 |
| Thickness D [$\mu$m] | 250 | 250 | 250 |
| White pigment concentration W [wt%] | 1.5 | 5 | 12 |
| Phosphorus content P [ppm by weight] | 29 | 92 | 32 |
| Intrinsic viscosity IV [dL/g] | 0.699 | 0.694 | 0.634 |
| Carboxyl end group content AV [equivalent/t] | 20.9 | 24.0 | 28.2 |

Table 6

| | Comparative Examples | | | | | |
|---|---|---|---|---|---|---|
| | 1 | 2 | 3 | 4 | 5 | 6 |
| Hydrolysis resistance | A | C | C | A | C | C |
| Ultraviolet light resistance | B | A | B | C | B | A |
| Optical density | D | A | A | C | B | A |
| Light reflectance | C | A | A | C | A | A |

As recognized from the above Examples in which the respective properties of the polyethylene terephthalate films (i.e., thickness, white pigment content, phosphorus element content, intrinsic viscosity and carboxyl end group content) were fallen within the above-specified ranges, the resulting films were capable of satisfying all of the hydrolysis resistance, ultraviolet light resistance, optical density and light reflectance as required. On the other hand, as recognized from the above Comparative Examples in which the respective properties of the polyethylene terephthalate films were out of the above-specified ranges, one or more of the hydrolysis resistance, ultraviolet light resistance, optical density and light reflectance of the resulting polyethylene terephthalate film were unable to be satisfied.

INDUSTRIAL APPLICABILITY

In accordance with the present invention, it is possible to provide a good biaxially oriented white polyethylene terephthalate film and a good backsheet for a photovoltaic module.

**Claims**

1. A biaxially oriented white polyethylene terephthalate film having a phosphorus element content of not more than 70 ppm by weight, a carboxyl end group content of not more than 26 equivalents/t, an intrinsic viscosity of not less than 0.65 dL/g, a white pigment concentration of 2.0 to 10.0% by weight and a thickness of not less than 175 $\mu$m.

2. A backsheet for a photovoltaic module comprising the biaxially oriented white polyethylene terephthalate film as defined in claim 1.

## INTERNATIONAL SEARCH REPORT

| | International application No. |
|---|---|
| | PCT/JP2011/065296 |

**A. CLASSIFICATION OF SUBJECT MATTER**
*H01L31/042*(2006.01)i, *C08G63/183*(2006.01)i, *C08G63/82*(2006.01)i, *C08J5/18* (2006.01)i

According to International Patent Classification (IPC) or to both national classification and IPC

**B. FIELDS SEARCHED**

Minimum documentation searched (classification system followed by classification symbols)
H01L31/042, C08G63/183, C08G63/82, C08J5/18

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2010-141291 A (Mitsubishi Plastics, Inc.), 24 June 2010 (24.06.2010), claim 1; paragraphs [0012], [0013], [0018], [0024], [0027], [0041] (Family: none) | 1-2 |
| A | JP 2002-26354 A (Toray Industries, Inc.), 25 January 2002 (25.01.2002), claim 3; paragraphs [0030], [0068], [0069] (Family: none) | 1-2 |
| A | WO 2006/106844 A1 (Toppan Printing Co., Ltd.), 12 October 2006 (12.10.2006), paragraph [0033] & EP 1873841 A1 | 1-2 |

☐ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 08 September, 2011 (08.09.11) | 20 September, 2011 (20.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11261085 A
- JP 11186575 A
- JP 2002100788 A